(19) Europäisches Patentamt
European Patent Office
Office européen des brevets

(11) **EP 1 464 088 B1**

(12) **EUROPEAN PATENT SPECIFICATION**

(45) Date of publication and mention
of the grant of the patent:
**18.04.2007 Bulletin 2007/16**

(21) Application number: **02781692.5**

(22) Date of filing: **18.12.2002**

(51) Int Cl.:
*H01L 49/02* *(2006.01)*  *H05B 33/12* *(2006.01)*

(86) International application number:
**PCT/IB2002/005543**

(87) International publication number:
**WO 2003/058728 (17.07.2003 Gazette 2003/29)**

(54) **Electroluminescent device**

Elektrolumineszente Vorrichtung

Dispositif électroluminescent

(84) Designated Contracting States:
**AT BE BG CH CY CZ DE DK EE ES FI FR GB GR IE IT LI LU MC NL PT SE SI SK TR**

(30) Priority: **11.01.2002 IT TO20020033**

(43) Date of publication of application:
**06.10.2004 Bulletin 2004/41**

(73) Proprietor: **C.R.F. SOCIETÀ CONSORTILE PER AZIONI**
**10043 Orbassano (IT)**

(72) Inventors:
• **PERLO, Piero**
**I-12048 Sommariva Bosco (IT)**
• **LI PIRA, Nello**
**I-12045 Fossano (IT)**
• **MONFERINO, Rossella**
**I-10129 Torino (IT)**
• **REPETTO, Piermario**
**I-10145 Torino (IT)**
• **LAMBERTINI, Vito**
**I-10049 Giaveno (IT)**
• **PADERI, Marzia**
**I-10127 Torino (IT)**

(74) Representative: **Gallarotti, Franco et al**
**Buzzi, Notaro & Antonielli d'Oulx Srl,**
**Via Maria Vittoria, 18**
**10123 Torino (IT)**

(56) References cited:
**US-A- 5 796 120**

• **LI PIRA N ET AL: "MODELLING AND EXPERIMENTAL EVIDENCE OF QUANTUM PHENOMENA IN METALLIC NON-CONTINUOUS FILMS (METAL QUANTUM WIRE NETWORK - MQWN -)" PROCEEDINGS OF THE EUSPEN. INTERNATIONAL CONFERENCE, XX, XX, vol. 1, 27 May 2001 (2001-05-27), pages 212-215, XP008014567 Turin, Italy**
• **BAGRAEV N T ET AL: "Light emission from erbium-doped nanostructures embedded in silicon microcavities" TENTH INTERNATIONAL CONFERENCE ON MODULATED SEMICONDUCTOR STRUCTURES. MSS 10, LINZ, AUSTRIA, 23-27 JULY 2001, vol. 13, no. 2-4, pages 1059-1062, XP002240658 Physica E, March 2002, Elsevier, Netherlands ISSN: 1386-9477**
• **YAMAMOTO NAOKATSU ET AL: "Inverse-percolation model for investigating a mechanism of formation and photoluminescence of porous silicon" J LUMIN;JOURNAL OF LUMINESCENCE 1999 ELSEVIER SCIENCE PUBLISHERS B.V., AMSTERDAM, NETHERLANDS, vol. 82, no. 1, 1999, pages 85-90, XP002240659 ISSN: 0022-2313**

## Description

The present invention relates to an electroluminescent device.

More specifically, the present invention proposes the production of an electroluminescent device of novel conception, which is particularly susceptible to be applied to the field of photonics and is on a competitive level with traditional electroluminescent devices, such as LED and O-LED, both in terms of costs and attainable performances.

US 5,796,120 discloses a tunnel thin film electroluminescent device.

The object is attained, according to the present invention, by an electroluminescent device having the characteristics of the attached claims, which are an integral part of the present description.

Further objects, characteristics and advantages of the present invention shall become apparent from the description hereunder and the attached drawings, provided purely as a non-limitative example in which:

- figure 1 is a graphic representation of the potential barrier between a generic metal and the vacuum, in different conditions;
- figure 2 is a schematic representation of an electroluminescent device produced in accordance with the present invention;
- figure 3 is a schematic representation of an electroluminescent device produced in accordance with a first possible variant of the present invention;
- figure 4 is a schematic representation of an electroluminescent device produced in accordance with a second possible variant of the present invention.

The electroluminescent device according to the invention is based on the tunneling effect in a three-dimensional percolated layer.

A three-dimensional percolated layer is a metallic mesoporous structure, composed of metallic nanoparticles interconnected with one another or dielectric metallic interconnections connected in such a way as to guarantee electrical conduction; the interconnection or connection may be produced by tunneling, as will be explained hereunder. According to the invention, the cavities of micrometric or nanometric dimensions which are found in the mesoporous structure house luminescent nanoparticles or macromolecules; as will be seen, these emit light when they are energized by the electrons which, as a result of tunneling, pass through the percolated layer.

The commonly accepted definition for mesoporous materials comprises inorganic materials with pores with dimensions below 50 nm. Porous materials with pores of nanometric dimensions are the most difficult to produce. In particular, for orderly mesoporous materials *"supramolecular templating"* techniques are generally utilized, which use asymmetrical organic molecules as templates, to be removed once the nanoporous structure has been established. Metallic mesoporous materials can instead be grown using evaporation techniques, such as thermal evaporation or electron beam evaporation.

With regard to tunneling effect, it must here be considered that the metal-insulator interface is a typical situation inside a metallic system at percolation level, which occurs at each discontinuity of the system.

There are various electron transport mechanisms through the metal-insulator interface, such as ohmic conduction, ionic conduction, thermal emission and field effect emission. In a given material, each of the aforesaid mechanisms prevails in a certain temperature and voltage range (electric field) and has a characteristic dependence on the current, the voltage and the temperature. These different processes are not necessarily independent from one another.

Field emission, also called Fowler-Nordheim electron tunneling, consists in transporting electrons through a metal-insulator interface due to the passage, by tunneling effect, of the electrons from the Fermi level of the metal to the conduction band of the insulator means.

This tunnel effect occurs when there are strong electric fields (hence the term "emission for field effect") which are able to bend the energy bands of the insulator means to form a narrow triangular potential barrier between the metal and the insulator.

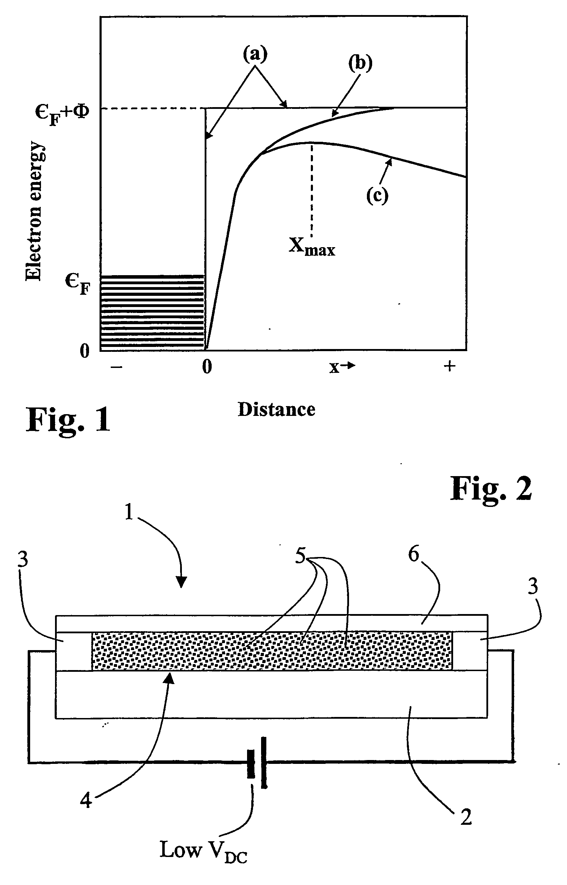

Figure 1 provides for this object a schematic representation of the potential barrier between a generic metal and the vacuum in three different possible situations.

Generally, it is assumed that the potential energy of an electron passes from zero inside the metal to the value $E_F+\Phi$ immediately outside the surface of the metal. In figure 1 this case is represented by the curve (a).

The potential barrier which an electron moving away from the metal encounters has instead a more gradual trend, as it is reasonable to think that initially the potential increases linearly with the distance from the surface of the metal; when an electron reaches the distance of a few Å (1 Å $\triangleq$ 0.1nm) from this surface it should feel the effect of an attractive force equivalent to the force due to a charge -*e*, in the presence of which the potential energy of the electron may be represented with a function of the type:

$$ V(x) = (E_F + \Phi) - \left( \frac{e^2}{16\pi\varepsilon_0 x} \right) $$

where x represents the distance of the electron from the surface of the metal. In figure 1 this case is represented by the curve (b).

Finally, if an electric field is applied in the direction X in the vacuum region surrounding the heated metal, the potential energy of the electron becomes of the type:

$$V(x) = (E_F + \Phi) - \left(\frac{e^2}{16\pi\varepsilon_0 x}\right) - exE$$

where E represents the electric field applied. By performing the derivative of this expression the presence of a maximum of the potential barrier is found, represented in figure 1 by the curve (c), which is found at:

$$\begin{cases} x_{\max} = (e/16\pi\varepsilon_0 E)^{1/2} \\ V_{\max} = V(x) = (E_F + \Phi) - (e^3 E/4\pi\varepsilon_0)^{1/2} \end{cases}$$

As can be seen in figure 1, the presence of an external electric field produces a slight decrease in the effective work function. The decrease in the value of the typical work function of the metal in the vacuum is small if the external electric field is not very intense (up to the value of a few thousands of volts/meter): in this case the maximum potential is found at many Å 1Å ≜ 0.1mm of distance from the external surface of the metal. Even a small decrease in the value of Φ makes the phenomenon of thermal emission possible for many electrons without sufficient energy to pass over the potential barrier in the absence of the external electric field.

When the electric field becomes very intense, around $10^9$ volts/meter, in addition to the decrease in the typical work function of the metal, the phenomenon of field effect emission or electron tunneling also occurs.

The potential barrier that is created at the metal-insulator surface becomes so thin that the electrons of the metal can pass through it by quantum tunneling. At a critical value of the electric field the potential barrier becomes thin enough and the electrons that are on the Fermi level of the metal acquire a finite probability of passing through it. For higher values of the electric field, the even thinner thickness of the potential barrier allows electrons with even lower energies to pass through by tunnel effect.

The current density of emission for field effect is strictly dependent on the intensity of the electric field, while it is substantially independent from the temperature:

$$j \propto E^2 \exp\left(-\frac{b\Phi}{E}\right)$$

where E represents the intensity of the electric field, Φ represents the height of the potential barrier and b is a constant of proportionality.

It is important to observe that, in the case of emission through electron tunneling, the electrons do not require thermal energizing (and this explains the fact that *j* does not depend on the temperature), but an intense electric field that reduces the thickness of the potential barrier bending the conduction and valence bands of the insulator means. This explains the strict dependence of *j* on the intensity of the electric field: in fact, in this case, the electrons do not pass over the potential barrier but tunnel through it.

There should only be a slight probability of tunneling for Fermi level electrons unless the barrier is thinner than 1nm (10Å). Therefore, it is reasonable to expect that the critical value of the electric field above which the phenomenon of emission through field effect will occur is about $3\cdot10^9$ volts/meter. However, this type of emission also occurs with macroscopic electric fields up to 30 times less intense. It is probable that local roughness in the surface of the metal is the cause of the presence of extremely intense electric fields, although only on a local scale, and that the majority of the emission by field effect comes from these zones.

Inside a percolated metallic system, and specifically at each metal-vacuum interface, there are local increases in the electric field that make it possible to reach the values of intensity of the electric field required for electron tunneling to take place. It is important to stress that the smaller the dimensions involved in the field emission phenomenon are, the greater the local increase in the electric field is. At each discontinuity of the percolated metallic system, where there is a local increase in the electric field and electron emission takes place by field effect, a local increase in the current density should occur. In fact, just as those deriving from thermal emission, the electrons emitted by field effect contribute to the total electric current. Due to this, the percolated metallic system should have a voltage-current characteristic with non-ohmic trend: the increase in the current with the voltage applied, thanks to the contributions of thermal emission and field effect emission, should be faster than it is in an ohmic conductor with linear characteristics.

In figure 2, the numeral 1 indicates as a whole an electroluminescent device produced according to the precepts of the present invention, the operation of which is based on the concepts set forth above.

The device 1 has a "Current In Plane" architecture and is formed of several parts, namely:

- a substrate, indicated with 2;
- two lateral electrodes, indicated with 3;
- a layer of metallic mesoporous material at percolation level, indicated with 4;
- luminescent nanometric inclusions 5 in the layer of percolated material 4;
- a transparent protective layer, indicated with 6.

The substrate 2 may be transparent and produced in common glass, prepared for example with an ultrasound cleaning process, or may be opaque and produced in plastic material. According to the invention, transparent substrates covered with special costly coatings, such as glass covered with ITO, used in O-LED, P-LED and liquid crystal device technology, are not in any case required.

The lateral electrodes 3 are positioned on the glass substrate 2 at the same level and are composed of a continuous metallic layer, deposited by evaporation; the metallic material utilized for the purpose may be copper, silver, gold, aluminum or similar.

The electric contact between the power generator, indicated schematically with "Low $V_{DC}$", of the electroluminescent device 1 and the active layer of the device, composed by the layer 4 of metallic mesoporous material at percolation level, is established through the electrodes 3.

At the ends of the layer 4, the electrodes 3 generate a difference of potential that induces tunneling of electric charge through this layer. If the voltage applied is high enough to create very intense local electric fields ($E \approx 10^7$ V/cm), electron conduction by tunneling as previously described occurs inside the metallic layer 4 at percolation.

The percolation point of a discontinuous metallic system is defined as the point in which the film changes from acting as an insulator, typical of the situation in which the film has a great number of discontinuities in relation to the metallic islands, to act as a conductor, typical of the situation in which as the metallic islands are predominant over the discontinuities in the film, direct "links" between its two ends are formed, in which conduction of electric current can take place.

In a discontinuous metallic film at percolation level there are different electron transport mechanisms. As mentioned, in addition to normal ohmic conduction of the current, other transport mechanisms occur which involve the interface zones between the metal and the discontinuities, in particular thermal emission and electron tunneling.

Thermal emission only occurs in discontinuous films for sufficiently high temperature values, while electron tunneling occurs prevalently in films characterized by a large number of discontinuities of extremely small size, where sufficiently intense local electric fields form.

Evidence of the electron tunneling phenomenon is given by the non-linear trend of the voltage-current characteristic shown by percolated metallic systems. These show a current discharge that occurs at a critical value of the applied voltage. The current discharge proves that the conductibility of the system increases suddenly at the critical voltage value: this means that by applying suitable voltage, at the discontinuities where sufficiently intense electric fields have been created, electron tunneling effect is obtained. The electrons extracted by the metallic islands towards the discontinuity zones contribute to the total current that passes through the system, thus becoming responsible for the current discharge which can be observed at macroscopic level.

It is this very phenomenon which makes the percolated metallic system very interesting for the applications in an electroluminescent device. In fact, electron emission by the metallic islands by electron tunneling effect is used to energize the luminescent particles 5, for instance in the form of semiconductor nanocrystals, metallic nanoparticles or molecules with phosphorescent properties, included in the cavities of the percolated metallic layer 4.

The electrons extracted by the metallic islands by electron tunneling have sufficient energy to energize luminescence in the luminescent nanoparticles enclosed in the matrix composed of the percolated metallic structure. The centers of luminescence with nanometric dimensions may be of various types. In particular they may be produced by:

- *organic phosphoruses,* that is luminescent organic molecules, evaporated together with the metallic structure, among which: Coumarin 7, Alumnium-8-hydroxyquinoline, Spiro compounds, electroluminescent polymers;

- *inorganic semiconductors (Si, CdSe, CdTe, "core-shell" CdSe/ZnS and CdSe/CdS structures),* prepared with self-assembly techniques (which allow control over the diameter of the particles), electrochemical deposition, Langmuir-Blodgett techniques; nanostructures of this type may, if energized by incident electrons with a certain amount of energy, emit photons in the visible field and the near-infrared;

- *metallic nanocrystals (Au, Ag, Co, Ni, Pt,-),* prepared for example chemically by reduction of metallic ions in solution or physically by evaporation of the metal at high temperature; on the nanometric scale, these metals behave similarly to a semiconductor and are capable of emitting, if energized, visible photons or in the near-infrared;

- luminescent *rare earths,* such as metalorganic compounds of europium, terbium (emission in the visible), erbium, ytterbium (emission in the infrared).

The transparent protective layer 6 of the device 1 according to the invention may finally be composed of very thin transparent glass (about 0.5 mm), produced with sol-gel process and deposited on the percolated metallic layer 4 by spin-coating, dip-coating, evaporation or sputtering, or may be produced with another transparent plastic dielectric.

This protective layer 6 does not require the introduction of a polarization film, as required in O-LED technology, for which it is essential to increase the contrast of the output light. The protective layer 6 of the device 1 according to the invention, in addition to being easy to prepare and deposit, thus reduces the total cost of the production process.

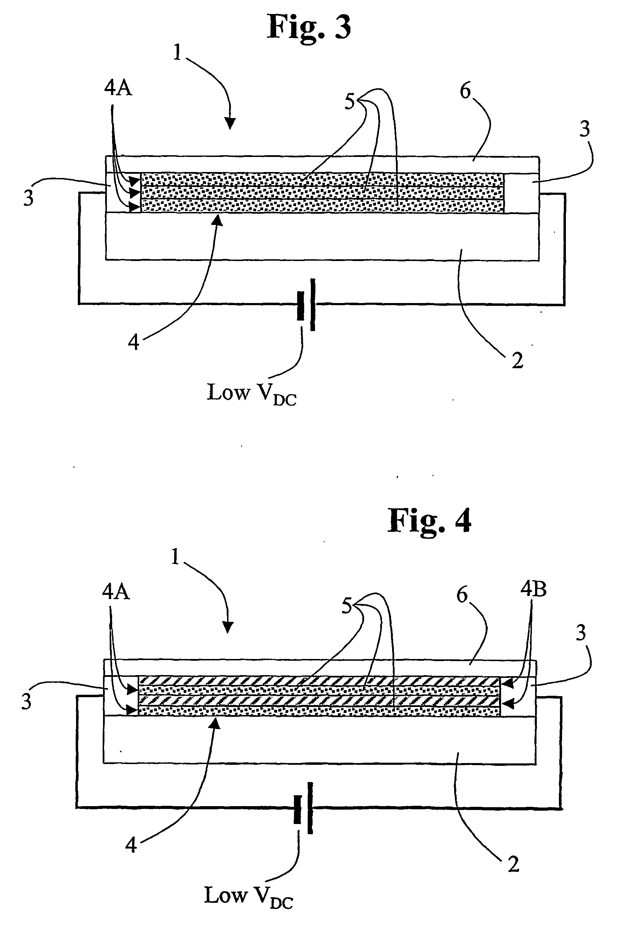

In the case shown in figure 2, the metallic mesoporous material 4 at percolation level is in the form of a single layer. In accordance with a possible variant, shown schematically in figure 3, the effect of extracting the electrons by the metallic islands which constitute the percolated layer may be increased by replacing the single layer 4 of figure 2 with a multi-layer percolated system.

The different layers may made of different metals or alternately metal/dielectric. In the first case, as shown in figure 3, all the layers of the system, indicated with 4A, must be at percolation level, to guarantee the same performances of electron transport obtained in the single layer, and must be distributed so as to be in direct contact with metals with different work functions (or extraction potentials). In the second case, as shown in figure 4, the various layers 4A of metal at percolation level must be alternated with discontinuous layers of dielectric material, one of which is indicated with 4B. The discontinuity of the dielectric layers 4B is essential to guarantee electric conduction throughout the multi-layer system (and not through each single metallic layer).

It is known that phenomena of electron emission by a metal, either due to thermal emission or electron tunneling, increase in intensity when atoms of an element characterized by a low work function are distributed on the surface of a metal characterized by a high work function value, and vice versa. The multi-layer solution ensures the electroluminescent device has an extremely vast contact area, which increases the possibilities of contact between metallic islands of different elements and contributes towards increasing the number of electrons extracted by tunneling effect. Combinations of metals for which electron emission by tunneling effect is possible for a few ElectronVolts applied to continuous electrodes are: Ca-Al, Ca-Ag, Ca-Cu, Ca-Au, Al-Au, Ag-Au.

The characteristics of the invention are clear from the description given. As well as increased stability, the advantages the new electroluminescent device draws from the characteristics of the percolated metallic layer include:

- the possibility of obtaining light emission in both directions, as a metallic system at percolation level is almost completely transparent;
- the use of solutions with multi-layer of different layers of discontinuous films has the advantage of increasing the total volume from which light is emitted.

It is clear to those skilled in the art that there are numerous possible variants to the electroluminescent device described as an example, without however departing from the scopes of intrinsic novelty of the invention.

**Claims**

1. An electroluminescent device (1) comprising:

   - a glass or plastic supporting substrate (2);
   - at least two electrodes (3) positioned on said substrate (2);
   - at least a three-dimensional percolated layer (4;4A) positioned on said substrate (2) between said electrodes (3), said three-dimensional percolated layer (4;4A) having a metallic mesoporous structure defining a multitude of cavities with micrometric or nanometric dimensions, said structure being in particular composed of metallic interconnections or metallic dielectrics interconnections connected so as to guarantee electric conduction;
   - a multitude of luminescent inclusions (5), in particular in the form of nanoparticles or macromolecules, housed in respective cavities of said three-dimensional percolated layer (4;4A),

   where said luminescent inclusions (5) are operative to emit light when energized by electrons which, as a result of electron tunneling effect, pass through said three-dimensional percolated layer (4;4A).

2. Device according to claim 1, **characterized in that** said electrodes (3) are operative to establish the electric contact between an external power generator (Low $V_{DC}$) and said three-dimensional percolated layer (4;4A), in order to generate to the ends of the latter a potential difference which induces transport of electric charge through the layer.

3. Device according to claim 1, **characterized in that** it is provided with a protective layer (6) of said three-dimensional percolated layer (4;4A).

4. Device according to claim 1, **characterized in that** said substrate (2) is produced in glass or plastic material.

5. Device according to claim 1, **characterized in that** said electrodes (3) are composed of a respective continuous metallic layer.

6. Device according to the preceding claim, **characterized in that** said continuous metallic layer is deposited by evaporation on said substrate (2).

7. Device according to claim 5, **characterized in that** said metallic layer is composed of a material selected in the group comprising copper, silver, gold, aluminum, platinum and nickel.

8. Device according to claim 1, **characterized in that** said luminescent inclusions (5) are in the form of semiconductor nanocrystals, metallic nanoparticles or molecules with phosphorescent properties.

9. Device according to claim 1, **characterized in that** said luminescent inclusions (5) are in the form of organic phosphoruses, such as Coumarin 7, Alumnium-8-hydroxyquinoline, Spiro compounds, electroluminescent polymers.

**10.** Device according to claim 1, **characterized in that** said luminescent inclusions (5) are in the form of inorganic semiconductors, such as Si, CdSe, CdTe, "core-shell" CdSe/ZnS and CdSe/CdS structures.

**11.** Device according to claim 1, wherein said luminescent inclusions (5) are in the form of metallic nanocrystals.

**12.** Device according to claim 1, **characterized in that** said luminescent inclusions (5) are in the form of luminescent rare earths, such as metalorganic compounds of europium, terbium, erbium and ytterbium.

**13.** Device according to claim 3, **characterized in that** said protective layer (6) is made of glass or another transparent plastic dielectric.

**14.** Device according to the preceding claim, **characterized in that** said glass is produced with sol-gel process and deposited on said percolated metallic layer (4;4A) by spin-coating, by dip-coating, by evaporation or by sputtering.

**15.** Device according to claim 1, **characterized in that** it is provided with a plurality of three-dimensional percolated layers (4A).

**16.** Device according to the preceding claim, **characterized in that** said layers (4A) are made of metals differing from one another or according to a repeated layout of the type metal-dielectric-metaldielectric.

**17.** Device according to claim 15, **characterized in that** said layers (4A) are made of one metal alternated with discontinuous layers of dielectric material (4B).

**Patentansprüche**

**1.** Elektrolumineszenzeinrichtung (1), umfassend:

- ein Glas- oder Kunststoffträgersubstrat (2);
- mindestens zwei auf dem Substrat (2) positionierte Elektroden (3);
- mindestens eine, auf dem Substrat (2) zwischen den Elektroden (3) positionierte dreidimensionale perkolierte Schicht (4;4A), wobei die dreidimensionale perkolierte Schicht (4;4A) eine metallische mesoporöse Struktur aufweist, die eine Vielzahl von Hohlräumen mit mikrometrischen oder nanometrischen Abmessungen definiert, wobei die Struktur insbesondere aus metallischen Zwischenverbindungen oder metallischen dielektrischen Zwischenverbindungen besteht, die so verbunden sind, daß eine elektrische Leitung garantiert wird;
- mehrere lumineszente Einschlüsse (5), insbesondere in der Form von Nanoteilchen oder Makromolekülen, in jeweiligen Hohlräumen der dreidimensionalen perkolierten Schicht (4;4A) untergebracht,

wobei die lumineszenten Einschlüsse (5) dahingehend arbeiten, Licht zu emittieren, wenn sie von Elektronen aktiviert werden, die in Folge des Elektronentunnelungseffekts durch die dreidimensionale perkolierte Schicht (4;4A) hindurchtreten.

**2.** Einrichtung nach Anspruch 1, **dadurch gekennzeichnet, daß** die Elektroden (3) dahingehend arbeiten, den elektrischen Kontakt zwischen einem externen Stromgenerator (niedriges $V_{DC}$) und der dreidimensionalen perkolierten Schicht (4;4A) herzustellen, um an den Enden letzterer eine Potentialdifferenz zu erzeugen, die den Transport einer elektrischen Ladung durch die Schicht induziert.

**3.** Einrichtung nach Anspruch 1, **dadurch gekennzeichnet, daß** sie mit einer Schutzschicht (6) der dreidimensionalen perkolierten Schicht (4;4A) versehen ist.

**4.** Einrichtung nach Anspruch 1, **dadurch gekennzeichnet, daß** das Substrat (2) in Glas- oder Kunststoffmaterial produziert ist.

**5.** Einrichtung nach Anspruch 1, **dadurch gekennzeichnet, daß** die Elektroden (3) aus einer jeweiligen kontinuierlichen metallischen Schicht bestehen.

**6.** Einrichtung nach dem vorausgegangenen Anspruch, **dadurch gekennzeichnet, daß** die kontinuierliche metallische Schicht durch Aufdampfung auf dem Substrat (2) abgeschieden wird.

**7.** Einrichtung nach Anspruch 5, **dadurch gekennzeichnet, daß** die metallische Schicht aus einem Material besteht ausgewählt aus der Gruppe bestehend aus Kupfer, Silber, Gold, Aluminium, Platin und Nickel.

**8.** Einrichtung nach Anspruch 1, **dadurch gekennzeichnet, daß** die lumineszenten Einschlüsse (5) in Form von Halbleiternanokristallen, metallischen Nanoteilchen oder Molekülen mit phosphoreszierenden Eigenschaften vorliegen.

**9.** Einrichtung nach Anspruch 1, **dadurch gekennzeichnet, daß** die lumineszenten Einschlüsse (5) in Form organischer Leuchtstoffe wie etwa Coumarin-7, Aluminium-8-hydroxychinolin, Spiro-Verbindungen, elektrolumineszenten Polymeren vorliegen.

**10.** Einrichtung nach Anspruch 1, **dadurch gekennzeichnet, daß** die lumineszenten Einschlüsse (5) in Form anorganischer Halbleiter wie etwa Si-, CdSe-, CdTe-, "Kern-Hülle"-CdSe/ZnS- und CdSe/CdS-Strukturen vorliegen.

**11.** Einrichtung nach Anspruch 1, wobei die lumineszenten Einschlüsse (5) in Form metallischer Nanokristalle vorliegen.

**12.** Einrichtung nach Anspruch 1, **dadurch gekennzeichnet, daß** die lumineszenten Einschlüsse (5) in Form lumineszenter seltener Erden wie etwa metallorganische Verbindungen von Europium, Terbium, Erbium und Ytterbium vorliegen.

**13.** Einrichtung nach Anspruch 3, **dadurch gekennzeichnet, daß** die Schutzschicht (6) aus Glas oder einem anderen transparenten Kunststoffdielektrikum besteht.

**14.** Einrichtung nach dem vorausgegangenen Anspruch, **dadurch gekennzeichnet, daß** das Glas mit einem Sol-Gel-Prozeß produziert und auf der perkolierten metallischen Schicht (4;4A) durch Aufschleudern, durch Tauchen, durch Aufdampfen oder durch Sputtern hergestellt wird.

**15.** Einrichtung nach Anspruch 1, **dadurch gekennzeichnet, daß** sie mit mehreren dreidimensionalen perkolierten Schichten (4A) versehen ist.

**16.** Einrichtung nach dem vorausgegangenen Anspruch, **dadurch gekennzeichnet, daß** die Schichten (4A) aus Metallen hergestellt sind, die voneinander differieren oder entsprechend einem wiederholten Layout von dem Typ Metall-Dielektrikum-Metall-Dielektrikum.

**17.** Einrichtung nach Anspruch 15, **dadurch gekennzeichnet, daß** die Schichten (4A) aus einem Metall abwechselnd mit diskontinuierlichen Schichten aus dielektrischem Material (4B) hergestellt sind.

## Revendications

**1.** Un dispositif électroluminescent (1), comprenant :

- un substrat support (2) en verre ou en matière plastique ;
- au moins deux électrodes (3) positionnées sur ledit substrat (2) ;
- au moins une couche tridimensionnelle (4 ;4A) percolée positionnée sur ledit substrat (2), entre lesdites électrodes (3), ladite couche percolée tridimensionnelle (4; 4A) comprenant une structure mésoporeuse métallique, définissant une multitude de cavités ayant des dimensions micrométriques ou nanométriques, ladite structure étant en particulier composée d'interconnexions métalliques, ou bien d'interconnections diélectriques métalliques, connectées de manière à garantir une conduction électrique,
- une multitude d'inclusions luminescentes (5), en particulier sous forme de nanoparticules ou de macromolécules, logées dans des cavités respectives de ladite couche percolée tridimensionnelle (4 ; 4A),

dans lequel lesdites inclusions luminescentes (5) fonctionnent pour émettre de la lumière une fois alimentées en énergie par des électrons, qui, en conséquence de l'effet tunnel des électrons, traversent ladite couche percolée tridimensionnelle (4 ;4A).

**2.** Dispositif selon la revendication 1, **caractérisé en ce que** lesdites électrodes (3) fonctionnent pour établir le contact électrique entre un générateur d'énergie externe (Low $V_{DC}$) et ladite couche tridimensionnelle (4 ; 4A) percolée, afin de générer aux extrémités de cette dernière, une différence de potentiel induisant un transport de charge électrique à travers la couche.

**3.** Dispositif selon la revendication 1, **caractérisé en ce qu'**il est muni d'une couche protectrice (6) de ladite couche tridimensionnelle (4 ; 4A) percolée.

**4.** Dispositif selon la revendication 1, **caractérisé en** en ce que ledit substrat (2) est produit en verre ou matière plastique.

**5.** Dispositif selon la revendication 1, **caractérisé en ce que** lesdites électrodes (3) sont composées d'une couche métallique continue respective.

**6.** Dispositif selon la revendication précédente, **caractérisé en ce que** ladite couche métallique continue est déposée par évaporation sur ledit substrat (2).

**7.** Dispositif selon la revendication 5, **caractérisé en ce que** ladite couche métallique est composée d'un matériau sélectionné dans le groupe comprenant le cuivre, l'argent, l'or, l'aluminium, le platine et le nickel.

**8.** Dispositif selon la revendication 1, **caractérisé en ce que** lesdites inclusions luminescentes (5) se présentent sous la forme de nanocristaux de semi-conducteurs, de nanoparticules métalliques ou de molécules ayant des propriétés phosphorescentes.

**9.** Dispositif selon la revendication 1, **caractérisé en ce que** lesdites inclusions luminescentes (5) se présentent sous la forme de phosphores organiques, tels que la coumarine 7, l'aluminium-8-hydroxyquinoléine, les composés spiro, les polymères électroluminescents.

**10.** Dispositif selon la revendication 1, **caractérisé en ce que** lesdites inclusions luminescentes (5) se présentent sous la forme de semi-conducteurs non organiques, tels que Si, CdSe, CdTe, des structures "core-shell" CdSe/ZnS et CdSe/CdS.

**11.** Dispositif selon la revendication 1, dans lequel lesdites inclusions luminescentes (5) se présentent sous la forme de nanocristaux métalliques.

**12.** Dispositif selon la revendication 1, **caractérisé en ce que** lesdites inclusions luminescentes (5) se présentent sous la forme de terres rares luminescentes, telles que des composés organométalliques d'europium, de terbium, d'erbium et d'ytterbium.

**13.** Dispositif selon la revendication 3, **caractérisé en ce que** ladite couche protectrice (6) est formée de verre ou d'un autre matériau plastique diélectrique transparent.

**14.** Dispositif selon la revendication précédente, **caractérisé en ce que** ledit verre est produit avec un procédé sol-gel et est déposé sur ladite couche percolée métallique (4 ;4A), par revêtement par centrifugation, par revêtement par immersion, par évaporation ou par pulvérisation.

**15.** Dispositif selon la revendication 1, **caractérisé en ce qu'**il est muni d'une pluralité de couches percolées tridimensionnelles (4A).

**16.** Dispositif selon la revendication précédente, **caractérisé en ce que** lesdites couches (4A) sont formées de métaux différents les uns des autres ou selon un schéma répété du type métal-diélectrique-métal-diélectrique.

**17.** Dispositif selon la revendication 15, **caractérisé en ce que** lesdites couches (4A) sont formées d'un métal, alterné avec des couches discontinues de matériau diélectrique (4B).

**Fig. 1**

**Fig. 2**

# Fig. 3

Low V$_{DC}$

# Fig. 4

Low V$_{DC}$